Europäisches Patentamt

European Patent Office

Office européen des brevets

(19)

(11) Veröffentlichungsnummer : **0 013 943**

**B1**

(12) **EUROPÄISCHE PATENTSCHRIFT**

(45) Veröffentlichungstag der Patentschrift :
20.04.83

(51) Int. Cl.³ : **H 03 H 11/12**

(21) Anmeldenummer : **80100225.4**

(22) Anmeldetag : **17.01.80**

(54) **Monolithisch integrierbare Tiefpass-Filterschaltung.**

(30) Priorität : **29.01.79 DE 2903299**

(43) Veröffentlichungstag der Anmeldung :
**06.08.80 Patentblatt 80/16**

(45) Bekanntmachung des Hinweises auf die Patenterteilung : **20.04.83 Patentblatt 83/16**

(84) Benannte Vertragsstaaten :
**FR GB IT**

(56) Entgegenhaltungen :
**IEEE JOURNAL OF SOLID STATE CIRCUITS, Band SC-9, Nr. 4 ; August 1974, Seiten 196-199 New York, U.S.A. W.B. MIKHAEL et al. : « Economical Line Filtering for Business Communication Systems »**

**ELECTRONIC DESIGN, Band 15, Nr. 8, 12. April 1967, Seiten 78-82 Rochelle Park, U.S.A. R.S. MELSHEIMER : « If you need active filters »**

(73) Patentinhaber : **SIEMENS AKTIENGESELLSCHAFT Berlin und München Wittelsbacherplatz 2 D-8000 München 2 (DE)**

(72) Erfinder : **Kriedt, Hans Triester Strasse 33 D-8000 München 80 (DE)**
Erfinder : **Dietze, Andreas, Dipl.-Ing. Herrenchiemsee Strasse 36 D-8000 München 80 (DE)**

# 0 013 943

## Monolithisch integrierbare Tiefpaß filterschaltung

Die Erfindung betrifft einen monolithisch integrierbaren Tiefpaß, der aus einem Operationsverstärker mit einem nichtinvertierenden und einem invertierenden Eingangsanschluß sowie einem Ausgangsanschluß besteht, bei dem der Ausgangsanschluß unmittelbar mit dem invertierenden Eingangsanschluß verbunden und außerdem über die Reihenschaltung zweier Widerstände mit dem nichtinvertierenden Eingangsanschluß gekoppelt ist, bei dem ferner der nichtinvertierende Eingangsanschluß des Operationsverstärkers über einen Kondensator an das Bezugspotential gelegt und außerdem der Schaltungspunkt zwischen den beiden Widerständen an den Signaleingang des Tiefpasses gelegt und der Signalausgang des Tiefpasses durch den Ausgangsanschluß des Operationsverstärkers gegeben ist.

In der Literaturstelle « IEEE Journal of Solid-State Circuits, August 1974 » ist auf S. 196-199 eine Schaltung für einen Tiefpaß angegeben, welche — mit Ausnahme der monolithischen Integrierbarkeit — die soeben angegebenen Merkmale hat. Zwei weitere Merkmale sind für diese Schaltung charakteristisch. Das erste dieser Merkmale ist ein zweiter Kondensator, der den zwischen den drei genannten Widerständen liegenden Schaltungsknoten mit dem Ausgang des Operationsverstärkers verbindet. Das zweite Merkmal besteht in einem vierten ohmschen Widerstand, mit dem der besagte Schaltungsknoten mit dem Bezugspotential verbunden ist. Die beiden zuletzt genannten Merkmale verhindern, wie gemäß der Erfindung erkannt wurde, daß bei einer monolithischen Integration der bekannten Schaltung ein brauchbarer Tiefpaß erhalten wird. Dem entspricht auch, daß in der genannten Literaturstelle von einer Realisierung in monolithisch integrierter Halbleitertechnik nicht die Rede ist.

Es ist Aufgabe der Erfindung, ein monolithisch integrierbares Tiefpaßfilter anzugeben, welches sich mit möglichst geringem Aufwand monolithisch realisieren läßt.

Hierzu wird gemäß der Erfindung der eingangs definierte Tiefpaß derart ausgestaltet, daß zur Realisierung des Tiefpasses in monolithisch integrierter Form die Verbindung zwischen dem Signalausgang und dem nicht invertierenden Eingangsanschluß des Operationsverstärkers auschließlich durch die genannte Reihenschaltung der Widerstände gegeben ist, daß außerdem die einzige Verbindung zwischen dem nichtinvertierenden Eingangsanschluß des Operationsverstärkers und dem Bezugspotential außerhalb der üblichen Spannungsversorgung für den Operationsverstärker ausschließlich durch den genannten Kondensator gegeben ist, und daß schließlich dieser Kondensator und auch die Widerstände so bemessen sind, daß sie sich innerhalb einer monolithisch integrierbaren Schaltung realisieren lassen.

Bekanntlich bauen sich Schaltungen für einen Tiefpaß als RC-Kombinationen auf, wobei die in der Halbleitertechnik zur Verfügung stehenden Realisierungen für die RC-Glieder erfahrungsgemäß zu hohen Eckfrequenzen führen. Um niedrigere Eckfrequenzen zu erreichen, müssen bei den bekannten Anordnungen dieser Art äußere Schaltungsmittel zu Hilfe genommen werden. Es ist nun Aufgabe der Erfindung, eine im vollen Maße integrierbare Halbleiter-Tiefpaßfilterschaltung anzugeben, welche ohne weiteres Eckfrequenzen erreichen läßt, die im NF-Bereich liegen und die deshalb einen weitgehenden Einsatz auf dem NF-Gebiet, sei es bei Anwendung von AM-Technik, sei es bei Anwendung von MF-Technik erlaubt.

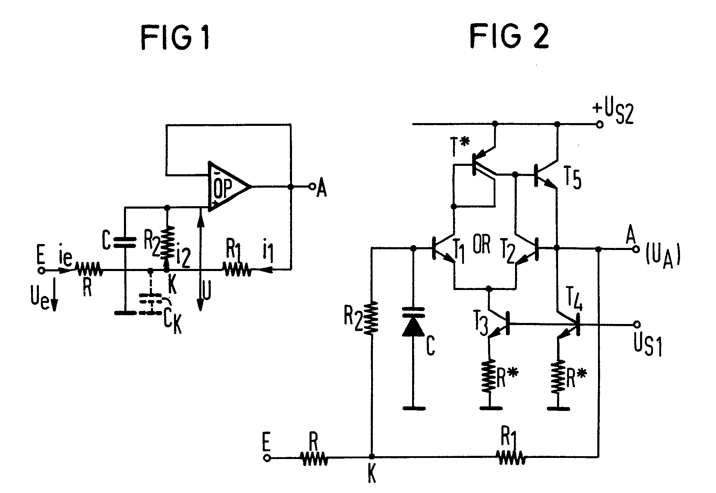

Die der Erfindung entsprechende Lösung ist in Figur 1 in verallgemeinerter Form und in Figur 2 in einer bevorzugten Ausgestaltung gezeigt. Vorher soll jedoch noch folgendes festgestellt werden.

Die Unterschiede der erfindungsgemäßen Schaltung für einen Tiefpaß gegenüber den bekannten Tiefpaßschaltungen nach « IEEE Journal of Solid-State Circuits » (August 1974), S. 197, ermöglichen es, die an sich bekannte Transformation der Kapazität eines Kondensators in einen anderen — höheren — Wert mittels eines Operationsverstärkers mit Erfolg anzuwenden. Aus diesem Grunde ist es bei dem erfindungsgemäßen Tiefpaß möglich, mittels integrierbarer Kondensatoren Eckfrequenzen $f_o$ zu realisieren, wie sie für leistungsfähige Tiefpässe im Niederfrequenzbereich erforderlich sind.

Bei der in Figur 1 und in Figur 2 dargestellten Schaltung für einen Tiefpaß gemäß der Erfindung ist der Kondensator C durch eine monolithisch integrierbare Kapazität, z. B. eine Sperrschichtkapazität oder eine MOS-Kapazität zu realisieren. Der direkte Eingang, d. h. also der nichtinvertierende Eingang « + » des Operationsverstärkers OP ist bei der in Figur 2 dargestellten Realisierung durch den Basisanschluß eines ersten npn-Transistors $T_1$ gegeben, dessen Emitter zusammen mit dem Emitter eines zweiten npn-Transistors $T_2$ an eine Stromquelle — hier an den Kollektor eines dritten npn-Transistors $T_3$ geschaltet ist. Demgemäß liegt der Emitter des dritten npn-Transistors $T_3$ über einen Vorwiderstand am Bezugspotential, also an Masse, während seine Basis — zusammen mit der Basis eines ebenfalls mit seinem Emitter über einen Vorwiderstand R* am Bezugspotential liegenden — vierten npn-Transistors $T_4$ gegenüber Masse (Bezugspotential) durch eine erste Stabilisierungsspannung $U_{s1}$ beaufschlagt ist. Die Stromquellen, hier aus $T_3$, R* und $T_4$, R* bestehend, können durch jede andere Art von Stromquelle ersetzt werden.

Der Kollektor des ersten npn-Transistors $T_1$ ist mit der Basis und dem ersten Kollektor eines pnp-Transistors T* verbunden, dessen Emitter gegenüber Masse durch eine zweite (positive) Bezugsspannung $U_{s2}$ beaufschlagt ist. Der zweite Kollektor des pnp-Transistors T* ist außerdem mit der Basis eines fünften npn-Transistors $T_5$ verbunden, dessen Kollektor gegenüber Masse durch das genannte zweite Stabilisierungspotential $U_{s2}$ vorgespannt ist und dessen Emitter auf die Basis des zweiten npn-Transistors $T_2$ geschaltet ist.

Der zweite Kollektor des pnp-Transistors T* liegt außerdem am Kollektor des zweiten npn-Transistors

$T_2$. Damit bilden die Transistoren $T_1$, $T^*$ und $T_2$ eine Stromspiegel-Schaltung. Der Ausgang A der Schaltung und damit des Operationsverstärkers OP ist durch die Basis des zweiten npn-Transistors $T_2$ gegeben, die einerseits mit dem Kollektor des bereits genannten vierten npn-Transistors $T_4$ verbunden ist und andererseits — entsprechend der oben gegebenen Definition der Erfindung — sowohl über den Widerstand $R_1$ an den Schaltungsknoten K gelegt als auch — über das Zusammenwirken des zweiten npn-Transistors $T_2$ mit dem pnp-Transistor $T^*$ und dem fünften npn-Transistor $T_5$ — an den invertierenden Eingang des Operationsverstärkers OP angeschlossen ist. Im übrigen entspricht auch die Anschaltung des Signaleingangs über den Vorwiderstand R an den Schaltungsknoten K und die Verbindung dieses Knotens K mit dem nichtinvertierenden Eingang des Operationsverstärkers OP über den Widerstand $R_2$ sowie die Anschaltung des nichtinvertierenden Eingangs des Operationsverstärkers OP über den Kondensator C an das Bezugspotential völlig der Definition der Erfindung und der in Fig. 1 dargestellten allgemeineren Schaltung. Das Ausgangssignal wird zwischen dem Ausgang A des Operationsverstärkers OP und Masse abgenommen.

Bezeichnet man den über den Eingang E der Schaltung fließenden Strom mit $i_e$, die zugehörige Eingangsspannung mit $u_e$, den Strom über den Widerstand $R_2$ mit $i_2$ und den Strom über den Widerstand $R_1$ mit $i_1$ und die Spannung am Ausgang A mit $u_a$, dann hat man auf Grund der Kirchhoffschen Gesetze :

$$i_e = i_2 - i_1.$$

Ist ferner $u_C$ die Spannung am Kondensator C und $u_K$ die Spannung zwischen dem Knoten K und Masse, so folgt auf Grund der den Operationsverstärkern eigentümlichen Eigenschaft, daß die Spannungen am invertierenden und am nichtinvertierenden Eingang gleich sind :

$$u_a = u_C$$

und damit

$$i_1 = (u_C - u_K)/R_1 \text{ und } i_2 = (u_K - u_C)/R_2.$$

Damit wird der über den Eingang E fließende Strom

$$i_e = [(u_K - u_C)/R_2] - [(u_C - u_K)/R_1],$$

also

$$i_e = u_K (R_1^{-1} + R_2^{-1}) - u_C (R_1^{-1} + R_2^{-1}).$$

Für die Spannung $u_C$ am Kondensator C folgt dann :

$$u_C = i_2/(s \cdot C) = (u_K - u_C)/(s \cdot R_2 \cdot C),$$

mit

$$s = \sigma + 2\pi \cdot f \cdot \sqrt{-1},$$

wobei

$$f = \text{Frequenz}$$

$$\sigma \to 0.$$

Daraus ergibt sich weiter :

$$u_C = u_K/(s \cdot R_2 \cdot C + 1) \tag{1}$$

und für die virtuelle Kapazität $C_K$ des Knotens K gegen Masse, die sich aus dem Verhältnis $i_e/u_e$ gemäß

$$s \cdot C_K = i_e/u_K$$

berechnet, die Beziehung

$$s \cdot C_K = [s \cdot C \cdot (1 + R_2/R_1)]/[(1 + s \cdot R_2 \cdot C)]. \tag{2}$$

Damit gilt für die Übertragungsfunktion A(s) der Filterschaltung wegen

3

# 0 013 943

$$u_C = u_K \cdot [1 + \{s \cdot (1 + R_2/R_1) \cdot C \cdot R\} / \{1 + s \cdot C \cdot R_2\}]$$

die Beziehung

$$A(s) = u_a/u_C = [1 + s \cdot C \cdot \{(1 + R_2/R_1) \cdot R + R_2\}]^{-1}. \qquad (3)$$

Für tiefe Frequenzen kann der Summand $s \cdot C \cdot R_2$ vernachlässigt werden und man hat

$$C_K = C \cdot (1 + R_2/R_1). \qquad (4)$$

Die Eckfrequenz ist als diejenige Frequenz definiert, bei der die Signalamplitude nach dem Durchgang durch das Filter auf 6 dB abgefallen ist. Sie errechnet sich für den vorliegenden Fall zu

$$f_o = [2\pi \cdot C \cdot \{(1 + R_2/R_1 \cdot R + R_2\}]^{-1}. \qquad (5)$$

Oberhalb von $f_o$ beträgt der Frequenzgang annähernd — 6 dB/Oktave.

Die beschriebene Schaltung erlaubt somit, wie man auf Grund der gebrachten Berechnung leicht einsieht, daß der Wert einer integrierten Kapazität C auf den Wert $C_K$ transformiert, vervielfacht als Tiefpaß-Kondensator zur Verfügung steht.

Dieses Verhalten ist durch die mittels eines Operationsverstärkers OP in der angegebenen Schaltung bewirkte Kapazitätstransformation ermöglicht.

Es kann noch darauf hingewiesen werden, daß auch andere Schaltungen als die aus Fig. 2 ersichtliche Ausgestaltung für den Operationsverstärker OP zulässig sind. Desgleichen kann auch die in Fig. 2 dargestellte Schaltung einerseits durch Umkehr der Polarität der dort angegebenen Bipolartransistoren, also durch Verwendung von pnp-Transistoren für die Transistoren $T_1$ bis $T_5$ und eines npn-Transistors für den Transistor T*, abgeändert werden. Hierdurch wird lediglich eine Änderung des Vorzeichens der Betriebsspannungen $U_{s1}$ und $U_{s2}$ erforderlich. Auch eine Darstellung sowohl in einfacher als auch in komplementärer MOS-Technik ist möglich.

## Ansprüche

1. Monolithisch integrierbarer Tiefpaß, der aus einem Operationsverstärker (OP) mit einem nichtinvertierenden und einem invertierenden Eingangsanschluß sowie einem Ausgangsanschluß besteht, bei dem der Ausgangsanschluß unmittelbar mit dem invertierenden Eingangsanschluß verbunden und außerdem über die Reihenschaltung zweier Widerstände ($R_1$, $R_2$) mit dem nichtinvertierenden Eingangs-anschluß gekoppelt ist, bei dem ferner der nichtinvertierende Eingangsanschluß des Operationsverstärkers (OP) über einen Kondensator (C) an das Bezugspotential gelegt und außerdem der Schaltungspunkt zwischen den beiden Widerständen ($R_1$, $R_2$) über einen dritten Widerstand (R) an den Signaleingang (E) des Tiefpasses gelegt und der Signalausgang (A) des Tiefpasses durch den Ausgangsanschluß des Operationsverstärkers (OP) gegeben ist, dadurch gekennzeichnet, daß zur Realisierung des Tiefpasses in monolithisch integrierter Form die Verbindung zwischen dem Signalausgang (A) und dem nichtinvertierenden Eingangsanschluß (+) des Operationsverstärkers (OP) ausschließlich durch die genannte Reihenschaltung der Widerstände ($R_1$, $R_2$) gegeben ist, daß außerdem die einzige Verbindung zwischen dem nichtinvertierenden Eingangsanschluß (+) des Operationsverstärkers (OP) und dem Bezugspotential außerhalb der üblichen Spannungsversorgung für den Operationsverstärker (OP) ausschließlich durch den genannten Kondensator (C) gegeben ist, und daß schließlich dieser Kondensator (C) und auch die Widerstände ($R_1$, $R_2$, R) so bemessen sind, daß sie sich innerhalb einer monolithisch integrierbaren Schaltung realisieren lassen.

2. Vorrichtung nach Anspruch 1, dadurch gekennzeichnet, daß die Schaltung in Bipolar-Halbleitertechnik realisiert ist.

3. Vorrichtung nach Anspruch 1 und 2, dadurch gekennzeichnet, daß der nichtinvertierende Eingangsanschluß des Operationsverstärkers (OP) durch den Basisanschluß eines ersten Transistors ($T_1$) gegeben und der Emitter dieses Transistors mit dem Emitter eines zweiten Transistors ($T_2$) verbunden ist, daß dabei der Kollektor des ersten Transistors ($T_1$) mit der Basis und dem einen Kollektor eines Stromspiegel-Transistors (T*) und der Kollektor des zweiten Transistors ($T_2$) mit dem zweiten Kollektor des Stromspiegeltransistors (T*) sowie mit der Basis eines fünften Transistors ($T_5$) verbunden ist, daß ferner der Emitter des Stromspiegeltransistors (T*) und der Kollektor des fünften Transistors ($T_5$) gegen Masse auf einem gemeinsamen Stabilisierungspotential ($U_{s2}$) liegen und der Emitter des fünften Transistors ($T_5$) mit der Basis des zweiten Transistors ($T_2$) sowie mit dem Kollektor eines vierten Transistors ($T_4$) und dem Ausgang (A) des Tiefpasses verbunden ist, daß außerdem die Emitteranschlüsse des ersten Transistors ($T_1$) und des zweiten Transistors ($T_2$) am Kollektor eines dritten Transistors ($T_3$) liegen, dessen Basis zusammen mit der Basis des vierten Transistors ($T_4$) gegen das Bezugspotential (Masse) durch ein weiteres Betriebspotential ($U_{s1}$) vorgespannt ist, während die Emitter des dritten und

4

des vierten Transistors ($T_3$, $T_4$) am Bezugspotential (Masse) liegen, daß weiterhin die Basis des ersten Transistors ($T_1$) über einen Kondensator (C) am Bezugspotential und über einen Widerstand ($R_2$) an einem Schaltungsknoten (K) liegt und dieser Schaltungsknoten (K) einerseits über einen Widerstand ($R_1$) an den Ausgang (A) des Tiefpasses und über einen anderen Widerstand (R) an den Signaleingang (E) des Tiefpasses gelegt ist und daß schließlich der Strom-Spiegeltransistor (T*) eine den übrigen Transistoren im Tiefpaß entgegengesetzte Dotierung seiner Zonen aufweist.

4. Vorrichtung nach Anspruch 3, dadurch gekennzeichnet, daß die Emitter des dritten und des vierten Transistors ($T_3$, $T_4$) über einen Vorwiderstand (R*) am Bezugspotential (Masse) liegen.

5. Vorrichtung nach Anspruch 3 oder 4, dadurch gekennzeichnet, daß der Stromspiegel-Transistor (T*) vom pnp-Typ und die übrigen Transistoren ($T_1$-$T_5$) vom npn-Typ sind.

6. Vorrichtung nach den Ansprüchen 1 bis 5, dadurch gekennzeichnet, daß der Kondensator (C) durch eine Sperrschicht oder durch eine MOS-Kapazität gegeben und zusammen mit den übrigen Teilen der Schaltung monolithisch zusammengefaßt ist.

## Claims

1. A monolithically integratable low-pass filter which consists of an operational amplifier (OP) having a non-inverting and an inverting input terminal and an output terminal, the output terminal being directly connected to the inverting input terminal and coupled via a series arrangement of two resistors ($R_1$, $R_2$) to the non-inverting input terminal, the non-inverting input terminal of the operational amplifier (OP) being connected via a capacitor (C) to the reference potential and the circuit point between the two resistors ($R_1$, $R_2$) being connected via a third resistor (R) to the signal input (E) of the low-pass filter, the signal output (A) of the low-pass filter being formed by the output terminal of the operational amplifier (OP), characterised in that the low-pass filter is constructed in a monolithically integrated form in that the connection between the signal output (A) and the non-inverting input terminal (+) of the operational amplifier (OP) is formed exclusively by the aforementioned series arrangement of the resistors ($R_1$, $R_2$), that the sole connection between the non-inverting input terminal (+) of the operational amplifier (OP) and the reference potential outside of the normal voltage supply for the operational amplifier (OP) is formed exclusively by the aforementioned capacitor (C), and that finally this capacitor (C) and likewise the resistors ($R_1$, $R_2$, R) are selected such that they can be constructed within a monolithically integratable circuit.

2. A device as claimed in Claim 1, characterised in that the circuit is designed in bipolar semiconductor technology.

3. A device as claimed in Claim 1 or 2, characterised in that the non-inverting input terminal of the operational amplifier (OP) is formed by the base terminal of a first transistor ($T_1$) and the emitter of this transistor is connected to the emitter of a second transistor ($T_2$), that the collector of the first transistor ($T_1$) is connected to the base and the first collector of a current mirror transistor (T*), whereas the collector of the second transistor ($T_2$) is connected to the second collector of the current mirror transistor (T*) and to the base of a fifth transistor ($T_5$), that moreover the emitter of the current mirror transistor (T*) and the collector of the fifth transistor ($T_5$) are connected to earth at a common stabilising potential ($U_{s2}$), and the emitter of the fifth transistor ($T_5$) is connected to the base of the second transistor ($T_2$) and to the collector of a fourth transistor ($T_4$) and the output (A) of the low-pass filter, that the emitter terminals of the first transistor ($T_1$) and of the second transistor ($T_2$) are connected to the collector of a third transistor ($T_3$) whose base, together with the base of the fourth transistor ($T_4$), is biassed towards reference potential (earth) by a further operating potential ($U_{s1}$), whereas the emitters of the third and fourth transistors ($T_3$, $T_4$) are connected to reference potential (earth), that moreover the base of the first transistor ($T_1$) is connected via a capacitor (C) to the reference potential and via a resistor ($R_2$) to a circuit node (K), and this circuit node (K) is connected on the one hand via a resistor ($R_1$) to the output (A) of the low-pass filter and also via another resistor (R) to the signal input (E) of the low-pass filter, and that finally the current mirror transistor (T*) features a doping of its zones which is opposed to the other transistors in the low-pass filter.

4. A device as claimed in Claim 3, characterised in that the emitters of the third and fourth transistors ($T_3$, $T_4$) are connected via a series resistor (R*) to the reference potential (earth).

5. A device as claimed in Claim 3 or 4, characterised in that the current mirror transistor (T*) is of the pnp-type, whereas the other transistors ($T_1$-$T_5$) are of the npn-type.

6. A device as claimed in the Claims 1 to 5, characterised in that the capacitor (C) is formed by a blocking layer or by a MOS-capacitance, and is monolithically combined with the other components of the circuit.

## Revendications

1. Filtre passe-bas monolithiquement intégrable qui est constitué par un amplificateur opérationnel (OP) comportant une borne d'entrée non inverseuse et une borne d'entrée inverseuse ainsi qu'une borne de sortie, dans lequel la borne de sortie est reliée directement à la borne d'entrée inverseuse et est couplée en outre à l'entrée non inverseuse par l'intermédiaire du circuit série de deux résistances ($R_1$, $R_2$), dans lequel en outre la borne d'entrée non inverseuse de l'amplificateur opérationnel (OP) est mise au potentiel de référence par l'intermédiaire d'un condensateur (C), et de plus le point de circuit entre les deux résistances ($R_1$, $R_2$) est relié à l'entrée de signaux du filtre passe-bas par l'intermédiaire d'une troisième résistance (R), et la sortie de signaux (A) du filtre passe-bas est formée par la borne de sortie de l'amplificateur opérationnel (OP), caractérisé par le fait que pour réaliser le filtre passe-bas sous forme intégrée monolithiquement la liaison entre la sortie de signaux (A) et la borne d'entrée non inverseuse (+) de l'amplificateur opérationnel (OP) est formée exclusivement par ledit circuit série des résistances ($R_1$, $R_2$), qu'en outre la liaison unique entre la borne d'entrée non inverseuse (+) de l'amplificateur opérationnel (OP) et le potentiel de référence est formée, en dehors de l'alimentation en tension classique pour l'amplificateur opérationnel (OP), par ledit condensateur (C), et qu'enfin ce condensateur (C) ainsi que les résistances ($R_1$, $R_2$, R) sont dimensionnés de manière à pouvoir être réalisés à l'intérieur d'un circuit intégrable monolithiquement.

2. Dispositif suivant la revendication 1, caractérisé par le fait que le circuit est réalisé suivant la technique des semiconducteurs bipolaires.

3. Dispositif suivant les revendications 1 et 2, caractérisé par le fait que la borne d'entrée non inverseuse de l'amplificateur opérationnel (OP) est formée par la borne de base d'un premier transistor ($T_1$) et l'émetteur de ce transistor est relié à l'émetteur d'un second transistor ($T_2$), que ce faisant le collecteur du premier transistor ($T_1$) est relié à la base et à un des collecteurs d'un transistor symétrique en courant (T*) et le collecteur du second transistor ($T_2$) est relié au second collecteur du transistor symétrique en courant (T*) ainsi qu'à la base d'un cinquième transistor ($T_5$), qu'en outre l'émetteur du transistor symétrique en courant (T*) et le collecteur du cinquième transistor ($T_5$) se trouvent à un potentiel de stabilisation commun ($U_{s2}$) par rapport à la masse, et l'émetteur du cinquième transistor ($T_5$) est relié à la base du second transistor ($T_2$) ainsi qu'au collecteur d'un quatrième transistor ($T_4$) et à la sortie (A) du filtre passe-bas, qu'en outre les bornes d'émetteur du premier transistor ($T_1$) et du second transistor ($T_2$) sont reliées au collecteur d'un troisième transistor ($T_3$) dont la base, en même temps que la base du quatrième transistor ($T_4$), est polarisée par rapport au potentiel de référence (masse) par un second potentiel de service ($U_{s1}$) tandis que les émetteurs des troisième et quatrième transistors ($T_3$, $T_4$) se trouvent au potentiel de référence (masse), que de plus la base du premier transistor ($T_1$) est reliée au potentiel de référence par l'intermédiaire d'un condensateur (C) et à un nœud du circuit (K) par l'intermédiaire d'une résistance ($R_2$), et que ce nœud de circuit (K) est relié d'une part, par l'intermédiaire d'une résistance ($R_1$) à la sortie (A) du filtre passe-bas et, par l'intermédiaire d'une autre résistance (R) à l'entrée de signaux (E) du filtre passe-bas, et qu'enfin le transistor symétrique en courant (T*) possède un dopage de ses zones opposé à celui des autres transistors dans le filtre passe-bas.

4. Dispositif suivant la revendication 3, caractérisé par le fait que les émetteurs des troisième et quatrième transistors ($T_3$, $T_4$) sont placés au potentiel de référence (masse) par l'intermédiaire d'une résistance de chute (R*).

5. Dispositif suivant l'une des revendications 3 ou 4, caractérisé par le fait que le transistor symétrique en courant (T*) est du type pnp et que les autres transistors ($T_1$-$T_5$) sont du type npn.

6. Dispositif suivant les revendications 1 à 5, caractérisé par le fait que le condensateur (C) est formé par une zone de transition ou par une capacité MOS et est réuni monolithiquement avec les autres parties du circuit.

# FIG 1

# FIG 2

1